# FASCICULE DE BREVET EUROPEEN

(11) **EP 2 325 915 B1**
(45) Date de publication et mention de la délivrance du brevet: **15.02.2017**
(21) Numéro de dépôt: 10191500.7
(22) Date de dépôt: 17.11.2010
(51) Int. Cl.: H01L 51/52, H01L 51/56, H01L 27/32

(54) **Dispositif d'affichage électronique à écran électroluminescent, et son procédé de fabrication.**
Elektronische Anzeigevorrichtung mit elektrolumineszierendem Bildschirm, und Verfahren zur dessen Herstellung
Electronic display device with electroluminescent screen, and process for its manufacture

(30) Priorité: 24.11.2009 FR 0905631
(43) Date de publication de la demande: 25.05.2011
(73) Titulaire: Commissariat à l'Énergie Atomique et aux Énergies Alternatives, 75015 Paris (FR)
(72) Inventeur: Vaufrey, David, 38000, Grenoble (FR); Flahaut, Thierry, 38220, Cholonge (FR)
(74) Mandataire: Gevers & Orès

(56) Documents cités:
- US-A1- 2003 116 772
- US-A1- 2003 201 716
- US-A1- 2007 018 150

## Description

La présente invention concerne un dispositif d'affichage électronique monochrome ou polychrome à écran électroluminescent, et son procédé de fabrication. L'invention s'applique en particulier à des micro-écrans ou micro-afficheurs à matrice active surmontés de diodes électroluminescentes organiques (« OLED » pour « organic light-emitting diode »).

De manière connue, les dispositifs d'affichage électroluminescents comprennent une zone d'émission formée d'une matrice de pixels, chaque pixel étant typiquement constitué de plusieurs sous-pixels de couleurs différentes (RVB : rouge, vert et bleu en général), et d'une zone de connexion électrique agencée de manière adjacente à cette zone d'émission. La réalisation de tels dispositifs de type micro-afficheurs ou micro-écrans, i.e. avec des pixels de moins de 50 µm de côté, soulève de nombreux problèmes techniques du fait de cette faible dimension visée et en particulier de l'utilisation de la technologie « OLED », qui utilise pour chaque pixel une structure multicouches émettrice de lumière comprenant un film organique intercalé entre deux électrodes interne et externe qui servent d'anode et de cathode, et dont l'une est transparente ou semi-transparente à la lumière émise alors que l'autre est généralement réfléchissante. On peut par exemple citer le document EP-A2-2 065 949 au nom de la Demanderesse pour la description d'un tel micro-écran « OLED ». D'autres dispositifs d'affichage sont déjà décrits dans les documents US 2007/0018150 A1 et US 2003/0201716 A1).

En effet, les « OLEDs » à base de petites molécules ne peuvent être microstructurées par les technologies classiques de la microélectronique et il est donc irréalisable de déposer spatialement sur une même électrode interne de base trois structures émettrices distinctes émettant respectivement dans le rouge, le vert et le bleu pour former les trois sous-pixels de chaque pixel. La faible dimension du pixel impose d'évaporer sous vide un émetteur blanc puis de le filtrer optiquement, les sous-pixels se distinguant les uns des autres par les électrodes internes de base sur lesquelles ils sont respectivement déposés.

Ces électrodes de base sont en général séparées entre elles par une résine électriquement isolante recouvrant le substrat et très souvent, suite à l'étape de gravure du dernier niveau métallique correspondant à chaque électrode de base, on met en oeuvre une étape de lithographie qui permet d'adoucir la topologie du substrat ainsi recouvert mais également de définir l'ouverture de chaque sous-pixel en relation avec la résine qui le recouvre partiellement à la périphérie de son électrode de base.

Cette étape de lithographie s'avère indispensable car l'épaisseur des couches « OLED » est très faible et par conséquent très sensible aux ruptures de pentes (d'autant plus que l'évaporation sous vide précitée n'est pas une méthode de dépôt conformant).

Cependant, un inconvénient majeur de cette lithographie est que l'ouverture de chaque sous-pixel (qui est d'autant plus élevée que la couverture de l'électrode de base correspondante par la résine est plus réduite) doit être inscrite dans la surface métallique non gravée de cette électrode de base. Il en résulte que la surface effective de la diode et, par conséquent, le taux d'ouverture du dispositif d'affichage (qui par définition correspond au rapport de la surface réellement émissive de l'écran sur sa surface totale) s'en trouvent réduits en proportion.

C'est la raison pour laquelle on cherche actuellement à accroître autant que possible le taux d'ouverture des afficheurs tant polychromes (i.e. définis par ces sous-pixels) que monochromes (i.e. uniquement définis par des pixels car étant exempts de sous-pixels) utilisant la technologie « OLED » car pour une luminance donnée de ces derniers (exprimée en cd/m²), plus le taux d'ouverture est grand, plus la densité de courant les parcourant est faible et donc plus le temps de vie de l'afficheur sera élevé. Cette maximisation du taux d'ouverture est particulièrement recherchée pour les micro-afficheurs à cause, d'une part, des faibles dimensions précitées de leurs pixels et, d'autre part, de l'utilisation de filtres colorés qui absorbent une partie non négligeable du flux lumineux émis.

Un but de la présente invention est de proposer un dispositif d'affichage électronique monochrome ou polychrome qui permette de répondre à ce besoin et qui remédie ainsi à l'inconvénient précité, ce dispositif comprenant une face d'émission électroluminescente et, vers l'intérieur de cette face, un substrat revêtu d'une matrice de pixels, chaque pixel étant constitué par une structure organique émettrice de rayonnements intercalée entre et en contact électrique avec deux électrodes respectivement proximale et distale vis-à-vis du substrat, une résine électriquement isolante recouvrant le substrat entre les électrodes proximales respectives des pixels et s'étendant en outre sur un bord périphérique de chaque électrode proximale.

A cet effet, un dispositif selon l'invention est tel que chaque pixel incorpore au moins une électrode auxiliaire transparente ou semi-transparente à ces rayonnements qui est à base d'un matériau métallique présentant un travail de sortie identique ou sensiblement identique à celui de l'électrode proximale et qui s'étend de manière inclinée à la surface de cette résine et en regard dudit bord de l'électrode proximale vers l'électrode distale, de sorte à maximiser la surface d'émission de chaque pixel et à faire varier l'épaisseur de la cavité optique formée entre l'électrode proximale de chaque pixel et l'électrode distale.

Avantageusement, ce dispositif peut être de type polychrome, chaque pixel étant dans ce cas constitué de sous-pixels de couleurs différentes qui sont formés par ladite structure émettrice intercalée entre lesdites électrodes proximales respectivement associées à ces sous-pixels et ladite électrode distale, au moins un sous-pixel de chaque pixel incorporant dans ce cas ladite au moins une électrode auxiliaire.

Par électrode « proximale », on entend dans la présente description l'électrode de base (i.e. interne, ou dernier niveau métallique) qui est associée à chaque pixel ou sous-pixel respectivement dans le cas d'un dispositif monochrome ou polychrome, et par électrode « distale » on entend l'électrode supérieure (i.e. externe) venant recouvrir la structure organique émettrice des rayonnements.

On notera que chaque électrode auxiliaire selon l'invention qui s'étend ainsi à partir de l'électrode de base d'un pixel ou sous-pixel en le prolongeant vers l'extérieur (i.e. vers l'électrode distale) à la manière d'une rampe, permet d'augmenter la surface émissive de ce pixel ou sous-pixel en comparaison de celle d'un pixel ou sous-pixel connu dont l'ouverture est uniquement délimitée par la résine, du fait que la conduction électrique planaire de cette électrode auxiliaire est supérieure à la conduction transverse des couches organiques de la structure émettrice la surmontant. La largeur périphérique de chaque électrode auxiliaire, qui peut par exemple varier de quelques dixièmes de microns à quelques microns, génère ainsi un bord périphérique luminescent pour le pixel ou sous-pixel correspondant, en plus et à l'instar de la partie centrale de ce dernier définie par la zone de l'électrode proximale non recouverte par la résine. Il en résulte une surface réellement luminescente augmentée pour l'ensemble des pixels du dispositif d'affichage et donc un taux d'ouverture pouvant être significativement accru pour ce dernier en comparaison de celui des dispositifs connus précités, ce qui se traduit par une densité de courant minimisée pour une valeur de luminance donnée et donc une durée de vie prolongée pour le dispositif de l'invention.

On notera également que chaque électrode auxiliaire est à base d'un matériau métallique présentant un travail de sortie identique ou sensiblement identique à celui de l'électrode proximale, pour ne pas former en cette électrode auxiliaire une diode auxiliaire qui fonctionnerait en parallèle avec la diode principale correspondant à l'électrode proximale non recouverte et dont l'impédance serait sensiblement différente de celle de cette diode principale. En effet, de telles différences d'impédances générées en parallèle pour chaque pixel ou sous-pixel induiraient une circulation du courant électrique majoritairement dans la diode de plus faible impédance, avec comme résultat indésirable la seule diode principale ou la seule diode auxiliaire qui serait réellement luminescente (i.e. à l'exclusion du bord périphérique ou de la partie centrale du pixel ou sous-pixel, respectivement).

De préférence, chaque électrode auxiliaire présente une épaisseur comprise entre 1 nm et 10 nm et est réalisée en un matériau métallique identique à celui de l'électrode proximale correspondante.

A titre encore plus préférentiel, le matériau métallique de l'électrode proximale et de l'électrode auxiliaire est constitué d'un corps simple, de préférence choisi dans le groupe constitué par le titane, le molybdène, le tungstène, le chrome, le nickel, le cuivre et l'or.

En variante, ce matériau métallique de l'électrode proximale et de l'électrode auxiliaire peut être constitué d'un corps composé choisi dans le groupe constitué par les oxydes transparents conducteurs tels que les oxydes d'étain-indium, les oxydes métalliques conducteurs de formule MₓO_{y} où M est un métal tel que le titane, le molybdène ou le tungstène, et les nitrures métalliques conducteurs de formule M'ₓN_{y} où M' est un métal tel que le titane.

On notera en outre que chaque électrode auxiliaire, qui est formée en surface de la résine en étant transparente ou semi-transparente (notamment dans le domaine visible), permet de faire varier spatialement l'épaisseur de la cavité optique du pixel ou sous-pixel correspondant qui est formée par les deux électrodes proximale et distale, étant précisé que cette épaisseur peut être modulée par la topologie locale de la résine sous-jacente. Il résulte de cette variation spatiale d'épaisseur de cavité optique une variation avantageuse de la réponse spectrale de celle-ci, comme cela sera expliqué ci-après.

Il convient de noter que chaque électrode auxiliaire présente l'avantage, du fait de sa transparence ou semi-transparence et également du fait qu'elle épouse précisément le profil en pente douce de la résine, de ne pas altérer le fonctionnement de cette cavité optique, notamment pour les structures émettrices blanches à large spectre filtré.

Selon une autre caractéristique de l'invention, dans chaque pixel ou dans ledit au moins un sous-pixel de chaque pixel (i.e. respectivement dans le cas d'un dispositif monochrome ou polychrome), l'électrode auxiliaire peut s'étendre obliquement à la manière d'une rampe périphérique continue en regard de tout le périmètre dudit bord recouvert par la résine, en présentant une hauteur mesurée à partir de ce bord qui croît de manière monotone.

Cette variation monotone croissante (i.e. exclusivement vers l'électrode distale) de chaque électrode auxiliaire permet d'amplifier les longueurs d'onde des sous-pixels les unes après les autres et d'élargir le spectre lumineux émis par l'ensemble des pixels du dispositif.

Avantageusement, chacun des sous-pixels de chaque pixel peut incorporer ladite électrode auxiliaire qui s'étend alors de préférence en regard de tout le périmètre dudit bord périphérique recouvert par la résine. De plus, ladite structure émettrice et ladite électrode distale suivent le profil incliné de chaque électrode auxiliaire.

Selon une autre caractéristique de l'invention, ce dispositif selon l'invention forme un microafficheur à substrat de type matrice active avec les structures émettrices qui forment des diodes électroluminescentes organiques (« OLED »), avec des pixels de moins de 50 µm de côté et des sous-pixels respectivement surmontés par des filtres optiques colorés (par exemple solidaires de la face interne d'un capot transparent de protection en verre ou en matière plastique qui est collé sur l'écran).

Un procédé de fabrication selon l'invention d'un dispositif d'affichage tel que défini ci-dessus comprend au moins une étape de gravure sèche mise en oeuvre sur le substrat surmonté desdites électrodes proximales et de la résine les reliant entre elles en leurs bords périphériques respectifs, cette gravure sèche étant réalisée par action mécanique d'un plasma qui est chimiquement inerte vis-à-vis de chaque électrode proximale et qui vient en extraire une partie du matériau non couvert par la résine pour l'implanter par ricochet sur une portion adjacente de cette résine surmontant ce bord, pour que chaque électrode auxiliaire ainsi implantée prolonge de manière inclinée l'électrode proximale dont elle est issue, de préférence sur tout le périmètre de cette électrode proximale.

Avantageusement, l'on peut utiliser pour cette étape de gravure sèche un plasma d'au moins un élément choisi dans la dernière colonne de la classification périodique, tel qu'un plasma à l'argon.

De préférence, on utilise pour chaque électrode proximale un matériau métallique constitué d'un corps simple, de préférence choisi dans le groupe constitué par le titane, le molybdène, le tungstène, le chrome, le nickel, le cuivre et l'or, pour que chaque électrode auxiliaire ainsi implantée soit constituée de ce même matériau suite à l'action mécanique de ce plasma.

En variante, on peut utiliser pour chaque électrode proximale un matériau métallique constitué d'un corps composé tel que défini ci-dessus et, après l'action mécanique de ce plasma, l'on soumet chaque électrode auxiliaire en cours d'obtention à un plasma de finition, tel qu'un plasma O₂ ou N₂-NH₃ dans le cas où l'électrode proximale est réalisée en un oxyde ou un nitrure métallique, respectivement, pour que chaque électrode auxiliaire ainsi implantée soit constituée du même matériau que l'électrode proximale dont elle est issue.

D'autres avantages, caractéristiques et détails de l'invention ressortiront du complément de description qui va suivre en référence à des dessins annexés, donnés uniquement à titre d'exemples et dans lesquels :
la figure 1 est une vue schématique partielle en coupe transversale d'un micro-écran selon l'invention en cours de fabrication, montrant le recouvrement partiel par une résine isolante des électrodes de base respectives de deux sous-pixels adjacents,
la figure 2 est une vue schématique partielle en coupe transversale montrant en agrandissement la zone encadrée de la figure 1 avec l'implantation sur la résine d'une électrode auxiliaire à partir d'une électrode de base suivi du dépôt de la structure émissive, de l'électrode externe et d'une couche de recouvrement pour le micro-écran,
la figure 3 est une photographie montrant la face externe d'émission d'un micro-écran dont les sous-pixels incorporent chacun une électrode auxiliaire selon la figure 2 mais réalisée en un matériau non conforme à l'invention, et
la figure 4 est un graphique montrant deux spectres d'émission (en UA) en fonction de la longueur d'onde (en nm) de rayonnements émis dans le domaine visible, respectivement par une diode selon l'invention et par une diode « témoin » dépourvue de toute électrode auxiliaire.

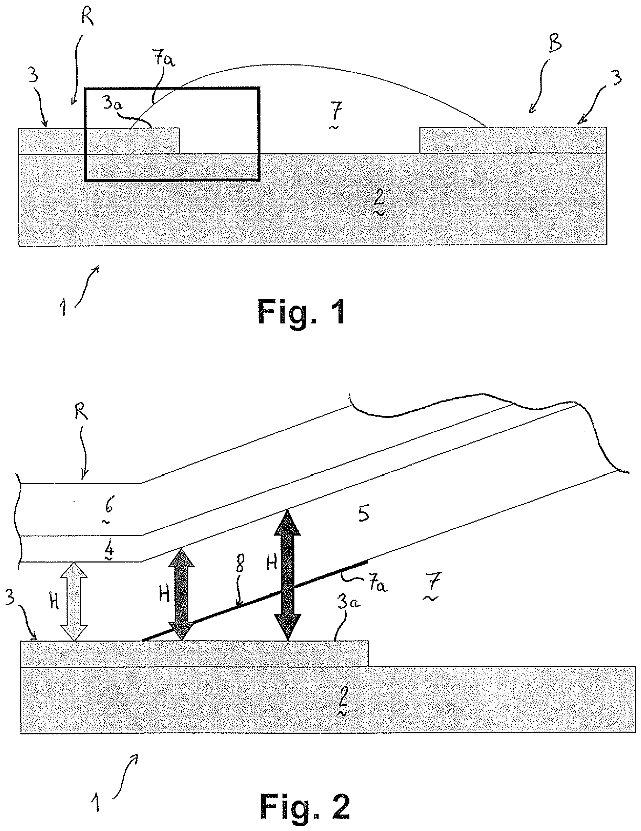

La description suivante de l'invention en référence aux figures 1 et 2 se rapporte à un micro-écran polychrome, mais on notera qu'elle pourrait également s'appliquer à un micro-écran monochrome à condition de remplacer les sous-pixels par des pixels.

Le micro-écran polychrome 1 selon l'invention schématisé en cours de fabrication aux figures 1 et 2 est de type à « OLED », et il comprend un substrat 2 par exemple en silicium revêtu d'une matrice active de pixels, dont deux sous-pixels ou points de couleurs adjacents R et B sont identifiés à la figure 1 pour chaque pixel par leur électrode de base 3 proximale vis-à-vis du substrat 2 qui est choisie transparente ou semi-transparente et qui joue par exemple le rôle d'une anode. Ce réseau d'électrodes de base 3 définissant l'ensemble des sous-pixels R, V, B de chaque pixel surmonte de manière connue une structure de circuit intégré du substrat 2 servant à adresser chaque pixel et pouvant comporter par exemple pour chaque pixel deux transistors et un condensateur ou des circuits plus complexes.

La matrice de pixels du micro-écran 1 est reliée à une zone de connexion électrique (non illustrée) pour l'établissement d'une différence de potentiel entre chaque électrode de base 3 et une électrode externe 4 formant par exemple la cathode qui est distale par rapport au substrat 2 et au contact de laquelle est intercalée une structure émettrice 5 à film organique monocouche ou multicouches (cette structure 5 est visible à la figure 2). Ce film organique intercalé entre les électrodes 3 et 4 est conçu pour transférer les électrons et les trous qui proviennent de ces électrodes 3 et 4 et qui sont recombinés pour générer des excitons et donc l'émission de lumière. Dans l'exemple de la figure 2, est en outre visible une couche de recouvrement 6 diélectrique et transparente à la lumière émise que l'on dépose sur l'électrode externe 4.

Préalablement au dépôt de la structure émettrice 5 sur les électrodes de base 3, on procède également de manière connue au dépôt d'une résine électriquement isolante 7 sur le substrat 2 (cette résine 7 étant choisie compatible avec les matériaux organiques utilisés pour la réalisation des diodes), de telle sorte que la résine 7 déposée relie toutes les électrodes 3 entre elles en les recouvrant partiellement en leurs bords périphériques 3a respectifs.

Selon l'invention, on met ensuite en oeuvre une étape de gravure sèche sur l'ensemble des électrodes de base 3 et sur la résine 7 par action mécanique d'un plasma choisi chimiquement inerte par rapport au matériau métallique de ces électrodes 3, pour extraire au niveau de chaque électrode 3 une partie de ce matériau non couvert (i.e. « ouvert ») par la résine 7 de manière à l'implanter par ricochet sur la portion périphérique 7a immédiatement adjacente de cette résine 7 (qui surmonte le bord périphérique 3a de chaque électrode 3). Comme visible à la figure 2, on obtient ainsi au bout d'un certain temps de gravure sèche une électrode auxiliaire 8 qui est formée à la surface de la portion périphérique 7a de la résine 7 en prolongeant obliquement, selon une hauteur H croissante, l'électrode de base 3 dont elle est issue sur tout le pourtour de celle-ci (i.e. en regard de son bord périphérique 3a).

La profondeur d'implantation ou épaisseur de cette électrode auxiliaire 8 est par exemple comprise entre 1 nm et 5 nm, étant précisé que cette profondeur est fonction du temps de gravure. Quant à la largeur de cette électrode 8 (mesurée à partir de l'électrode 3), elle est notamment fonction de la puissance de gravure utilisée et peut varier dans une certaine mesure par rapport au schéma de la figure 2.

Cette gravure sèche de chaque électrode 3 crée ainsi une électrode fine 8 transparente ou semi-transparente conductrice (à l'instar de cette électrode 3) qui permet d'augmenter la surface de chaque sous-pixel R, V, B grâce à sa conduction planaire de l'électricité et donc globalement d'augmenter le taux d'ouverture du micro-écran 1 en comparaison d'un micro-écran connu analogue mais dépourvu de telles électrodes auxiliaires 8, ce qui permet pour une valeur de luminance donnée de réduire la densité de courant nécessaire et donc d'augmenter la durée de vie du micro-écran 1.

Comme expliqué précédemment, on privilégie pour le matériau métallique de chaque électrode de base 3 un corps simple, tel que le titane, le molybdène, le tungstène, le chrome, le nickel, le cuivre ou l'or, pour que l'électrode auxiliaire 8 gravée sur la résine 7 par l'action mécanique du plasma soit constituée rigoureusement du même matériau que l'électrode de base 3 dont elle est issue.

Si l'on choisit d'utiliser pour chaque électrode de base 3 un matériau métallique composé (i.e. binaire ou tertiaire, par exemple, e.g. un oxyde d'étain-indium, un oxyde métallique MₓO_{y} où M est un métal tel que le titane, le molybdène ou le tungstène, ou un nitrure métallique M'ₓN_{y} où M' est un métal tel que le titane), alors on traite le matériau implanté mécaniquement à la surface 7a de la résine 7 par un plasma de finition de type O₂ qui oxyde les atomes métalliques implantés si ce matériau est un oxyde métallique ou de type N₂-NH₃ s'il s'agit d'un nitrure métallique, pour que chaque électrode auxiliaire 8 implantée soit finalement constituée du même matériau que l'électrode 3 dont elle dérive.

En effet, la gravure sèche mécanique induit une rupture des liaisons chimiques à l'intérieur d'un tel matériau composé d'électrode 3, ce qui signifie que seul un élément simple non volatile est effectivement implanté sur la résine 7 (en fait, l'oxygène ou l'azote selon le cas restent sous forme gazeuse et sont donc évacués par la pompe de l'équipement utilisé pour la gravure sèche). Or, comme il est très peu probable qu'un tel élément simple implanté présente un même travail de sortie que ce matériau composé de type oxyde ou nitrure, on aurait sans ce plasma de finition la formation de deux diodes présentant des impédances différentes en parallèle (l'une à l'emplacement de la portion « ouverte » de chaque électrode 3 et l'autre au niveau de l'électrode auxiliaire 8 l'entourant) avec comme conséquence que le courant électrique traverserait très majoritairement la diode de plus faible impédance et donc que seule la portion centrale « ouverte » ou seule la portion périphérique couverte de chaque sous-pixel R, V, B serait réellement émissive, ce que l'on souhaite bien entendu éviter.

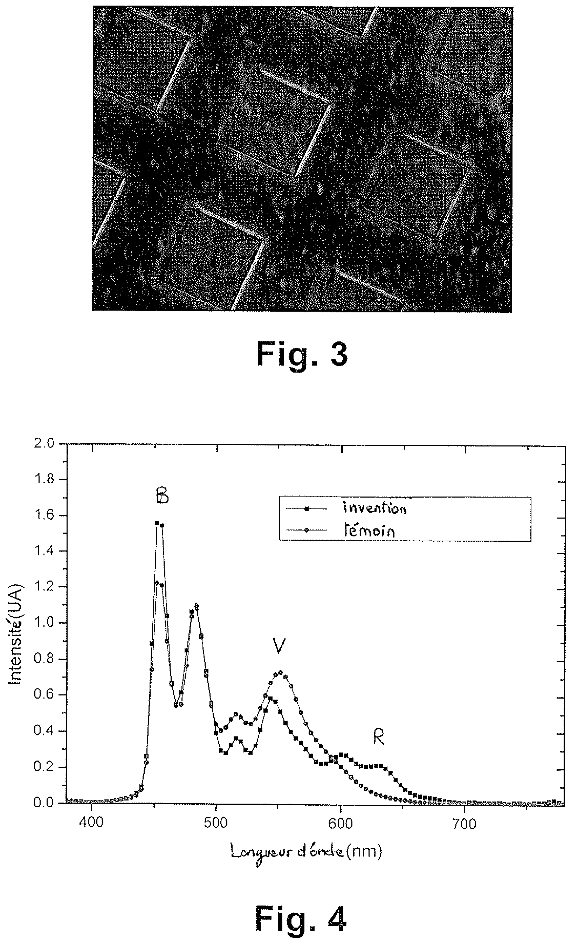

La photographie de la figure 3 illustre précisément une telle émission de lumière périphérique pour chaque sous-pixel R, V, B uniquement à l'emplacement de chaque électrode auxiliaire 8 en Ti (voir la bordure claire entourant chaque carré sombre) qui est implantée par un plasma à l'argon répondant à la dénomination « TELR P003 PM » à partir d'une électrode de base 3 en TiN, et qui génère une diode en parallèle d'impédance plus faible que celle de la portion « ouverte » de l'électrode 3. On notera qu'il suffirait de compléter cette gravure sèche par le plasma de finition N₂-NH₃ précité pour rendre cette portion « ouverte » émissive à l'instar de sa bordure. A titre indicatif en référence à l'exemple de la figure 3, chaque carré sombre définissant cette portion « ouverte » d'un sous-pixel R, V, B a pour dimensions 2,5 µm X 2,5 µm soit une aire de 6,25 µm², et comme la portion périphérique émissive au niveau de chaque électrode 8 présente dans cet exemple une largeur de 0,15 µm, on obtient grâce aux électrodes 8 de l'invention un gain de surface pour chaque sous-pixel de 0,15 X 2,5 X 4 = 1,5 µm², soit un accroissement de surface par sous-pixel d'environ 20 %.

Un autre avantage procuré par les électrodes auxiliaires 8 transparentes ou semi-transparentes selon l'invention est illustré à la figure 4, qui montre que la variation d'épaisseur de la cavité optique obtenue via l'électrode 8 pour cette diode « OLED » selon l'invention entre l'électrode de base 3 et l'électrode externe 4, permet d'amplifier successivement les longueurs d'onde émises dans le bleu, le vert puis le rouge et également d'élargir le spectre d'émission total de cette diode.

On voit en effet sur le graphique de la figure 4 que l'électrode 8 implantée par gravure sèche au moyen du même plasma à l'argon précité à la périphérie de l'électrode 3, confère à la courbe « invention » (dont les points reliés entre eux sont des carrés), en comparaison de celui de la courbe « témoin » (dont les points reliés entre eux sont des ronds) :
- un pic dans le bleu le plus profond (vers 450 nm) d'intensité lumineuse nettement supérieure, et parallèlement
- un élargissement du spectre total de la diode vers 650 nm (ce spectre illustré correspondant à la somme des deux spectres relatifs aux portions « ouverte » et couverte de l'électrode de base 3).

On a réalisé par ailleurs des mesures de coordonnées chromatiques, après utilisation de filtres optiques colorés, de cette diode « témoin » dépourvue d'électrode auxiliaire 8 et de cette diode selon l'invention l'incorporant par la gravure sèche précitée. A cet effet, on a établi pour chacune des deux diodes « témoin » et selon l'invention, trois diagrammes de chromaticité « CIE 1931 » y=f(x) sous forme de triangles des couleurs après apposition des filtres rouge, vert et bleu, qui ont montré que le rouge et le bleu étaient plus profonds après usage de ces filtres colorés pour la diode selon l'invention et donc que le triangle des couleurs obtenu grâce à l'électrode auxiliaire 8 était plus étendu.

## Revendications

1. Dispositif d'affichage électronique (1) comprenant une face d'émission électroluminescente et, vers l'intérieur de cette face, un substrat (2) revêtu d'une matrice de pixels, chaque pixel étant constitué par une structure organique (5) émettrice de rayonnements intercalée entre et en contact électrique avec deux électrodes respectivement proximale (3) et distale (4) vis-à-vis du substrat, une résine électriquement isolante (7) recouvrant le substrat entre les électrodes proximales respectives des pixels et s'étendant en outre sur un bord périphérique (3a) de chaque électrode proximale, **caractérisé en ce que** chaque pixel incorpore au moins une électrode auxiliaire (8) transparente ou semi-transparente à ces rayonnements qui est à base d'un matériau métallique présentant un travail de sortie identique ou sensiblement identique à celui de l'électrode proximale et qui s'étend de manière inclinée à la surface de cette résine et en regard dudit bord, de l'électrode proximale vers l'électrode distale, de sorte à maximiser la surface d'émission de chaque pixel et à faire varier l'épaisseur de la cavité optique formée entre l'électrode proximale de chaque pixel et l'électrode distale.

2. Dispositif (1) selon la revendication 1, **caractérisé en ce que** dans chaque pixel, ladite électrode auxiliaire (8) s'étend obliquement en regard de tout le périmètre dudit bord périphérique (3a) recouvert par ladite résine (7) en présentant une hauteur (H) mesurée à partir de ce bord qui est une fonction monotone croissante de la largeur dudit bord.

3. Dispositif (1) selon la revendication 1 ou 2, **caractérisé en ce que** chaque électrode auxiliaire (8) présente une épaisseur comprise entre 1 nm et 10 nm et est réalisée en un matériau métallique identique à celui de ladite électrode proximale correspondante.

4. Dispositif (1) selon la revendication 3, **caractérisé en ce que** le matériau métallique de chaque électrode proximale (3) et de ladite électrode auxiliaire (8) correspondante est constitué d'un corps simple, de préférence choisi dans le groupe constitué par le titane, le molybdène, le tungstène, le chrome, le nickel, le cuivre et l'or.

5. Dispositif (1) selon la revendication 3, **caractérisé en ce que** le matériau métallique de chaque électrode proximale (3) et de ladite électrode auxiliaire (8) correspondante est constitué d'un corps composé choisi dans le groupe constitué par les oxydes transparents conducteurs tels que les oxydes d'étain-indium, les oxydes métalliques conducteurs de formule MₓO_{y} où M est un métal tel que le titane, le molybdène ou le tungstène, et les nitrures métalliques conducteurs de formule M'ₓN_{y} où M' est un métal tel que le titane.

6. Dispositif selon une des revendications précédentes, ce dispositif étant de type polychrome, **caractérisé en ce que** chaque pixel est constitué de sous-pixels (R, V, B) de couleurs différentes qui sont formés par ladite structure organique émettrice (5) intercalée entre et en contact électrique avec lesdites électrodes proximales (3) respectivement associées à ces sous-pixels et ladite électrode distale (4), au moins un sous-pixel de chaque pixel incorporant ladite au moins une électrode auxiliaire (8).

7. Dispositif (1) selon la revendication 6, **caractérisé en ce que** chaque sous-pixel (R, V, B) de chaque pixel incorpore ladite électrode auxiliaire (8) qui s'étend en regard de tout le périmètre dudit bord périphérique (3a) recouvert par ladite résine (7), et **en ce que** ladite structure émettrice (5) et ladite électrode distale (4) suivent le profil incliné de chaque électrode auxiliaire.

8. Dispositif (1) selon la revendication 6 ou 7, **caractérisé en ce qu'**il forme un microafficheur dont les pixels font moins de 50 µm de côté et ont leurs sous-pixels (R, V, B) respectivement surmontés par des filtres optiques colorés, ledit substrat (2) étant de type à matrice active avec lesdites structures émettrices (5) qui forment des diodes électroluminescentes organiques (« OLED »).

9. Procédé de fabrication d'un dispositif d'affichage (1) selon une des revendications précédentes, **caractérisé en ce qu'**il comprend au moins une étape de gravure sèche mise en oeuvre sur le substrat (2) surmonté desdites électrodes proximales (3) et de la résine (7) les reliant entre elles en leurs bords périphériques (3a) respectifs, cette gravure sèche étant réalisée par action mécanique d'un plasma qui est chimiquement inerte vis-à-vis de chaque électrode proximale et qui vient en extraire une partie du matériau non couvert par la résine pour l'implanter par ricochet sur une portion adjacente (7a) de cette résine surmontant ce bord, pour que chaque électrode auxiliaire (8) ainsi implantée prolonge de manière inclinée l'électrode proximale dont elle est issue, de préférence sur tout le périmètre de cette électrode proximale.

10. Procédé fabrication selon la revendication 9, **caractérisé en ce que** l'on utilise pour cette étape de gravure sèche un plasma d'au moins un élément choisi dans la dernière colonne de la classification périodique, tel qu'un plasma à l'argon.

11. Procédé de fabrication selon la revendication 9 ou 10, **caractérisé en ce que** l'on utilise pour chaque électrode proximale (3) un matériau métallique constitué d'un corps simple, de préférence choisi dans le groupe constitué par le titane, le molybdène, le tungstène, le chrome, le nickel le cuivre et l'or, pour que chaque électrode auxiliaire (8) ainsi implantée soit constituée de ce même matériau suite à l'action mécanique de ce plasma.

12. Procédé de fabrication selon la revendication 9 ou 10, **caractérisé en ce que** l'on utilise pour chaque électrode proximale (3) un matériau métallique constitué d'un corps composé choisi dans le groupe constitué par les oxydes transparents conducteurs tels que les oxydes d'étain-indium, les oxydes métalliques conducteurs de formule MₓO_{y} où M est un métal tel que le titane, le molybdène ou le tungstène, et les nitrures métalliques conducteurs de formule M'ₓN_{y} où M' est un métal tel que le titane, et **en ce qu'**après l'action mécanique de ce plasma, l'on soumet l'électrode auxiliaire (8) en cours d'obtention à un plasma de finition, tel qu'un plasma O₂ ou N₂-NH₃ dans le cas où l'électrode proximale est réalisée en un oxyde ou un nitrure métallique, respectivement, pour que chaque électrode auxiliaire ainsi implantée soit constituée du même matériau que l'électrode proximale dont elle est issue.

## Patentansprüche

1. Elektronische Anzeigevorrichtung (1), umfassend eine elektrolumineszierende Sendeseite und zum Innern dieser Seite ein mit einer Pixelmatrix beschichtetes Substrat (2), wobei jedes Pixel von einer Strahlung sendenden organischen Struktur (5), angeordnet zwischen und in elektrischem Kontakt mit zwei, jeweils proximaler (3) und distaler (4), Elektroden gegenüber dem Substrat gebildet ist, wobei ein elektrisch isolierendes Harz (7) das Substrat zwischen den jeweiligen proximalen Elektroden der Pixel bedeckt und sich ferner auf einem peripheren Rand (3a) jeder proximalen Elektrode erstreckt, **dadurch gekennzeichnet, dass** jedes Pixel mindestens eine für diese Strahlungen transparente oder halbtransparente Hilfselektrode (8) inkorporiert, die auf der Basis eines metallischen Materials ist, aufweisend eine Ausgangsarbeit, die mit der der proximalen Elektrode identisch oder etwa identisch ist und die sich geneigt auf der Oberfläche dieses Harzes und gegenüber dem Rand von der proximalen Elektrode zur distalen Elektrode erstreckt, so dass die Sendeoberfläche jedes Pixels maximiert und die Dicke der optischen Kavität, die zwischen der proximalen Elektrode jedes Pixels und der distalen Elektrode gebildet ist, verändert wird.

2. Vorrichtung (1) nach Anspruch 1, **dadurch gekennzeichnet, dass** sich die Hilfselektrode (8) in jedem Pixel schräg gegenüber jedem Umfang des peripheren Rands (3a) erstreckt, der von dem Harz (7) bedeckt ist, aufweisend eine Höhe (H), gemessen ab diesem Rand, die eine monoton steigende Funktion der Breite des Rands ist.

3. Vorrichtung (1) nach Anspruch 1 oder 2, **dadurch gekennzeichnet, dass** jede Hilfselektrode (8) eine Dicke im Bereich von 1 nm bis 10 nm aufweist und aus einem metallischen Material hergestellt ist, das mit dem der entsprechenden proximalen Elektrode identisch ist.

4. Vorrichtung (1) nach Anspruch 3, **dadurch gekennzeichnet, dass** das metallische Material jeder proximalen Elektrode (3) und der entsprechenden Hilfselektrode (8) von einem einfachen Körper gebildet ist, vorzugsweise ausgewählt aus der Gruppe, die von dem Titan, dem Molybdän, dem Wolfram, dem Chrom, dem Nickel, dem Kupfer und dem Gold gebildet ist.

5. Vorrichtung (1) nach Anspruch 3, **dadurch gekennzeichnet, dass** das metallische Material jeder proximalen Elektrode (3) und der entsprechenden Hilfselektrode (8) von einem zusammengesetzten Körper gebildet ist, ausgewählt aus der Gruppe, die von den leitenden transparenten Oxiden gebildet ist wie den Zinn-Indium-Oxiden, den leitenden metallischen Oxiden der Formel MₓO_{y}, wobei M ein Metall wie das Titan, das Molybdän oder das Wolfram ist, und den leitenden metallischen Nitriden der Formel M'ₓN_{y}, wobei M' ein Metall wie das Titan ist.

6. Vorrichtung nach einem der vorangehenden Ansprüche, wobei diese Vorrichtung vom polychromen Typ ist, **dadurch gekennzeichnet, dass** jedes Pixel von Unterpixeln (R, V, B) unterschiedlicher Farben gebildet ist, die von der sendenden organischen Struktur (5) zwischen und in elektrischem Kontakt mit den proximalen Elektroden (3) gebildet sind, die jeweils diesen Unterpixeln und der distalen Elektrode (4) zugeordnet sind, wobei mindestens ein Unterpixel jedes Pixels die mindestens eine Hilfselektrode (8) inkorporiert.

7. Vorrichtung (1) nach Anspruch 6, **dadurch gekennzeichnet, dass** jedes Unterpixel (R, V, B) jedes Pixels die Hilfselektrode (8) inkorporiert, die sich gegenüber dem gesamten Umfang des peripheren Rands (3a), der von dem Harz (7) bedeckt ist, erstreckt und dass die sendende Struktur (5) und die distale Elektrode (4) dem geneigten Profil jeder Hilfselektrode folgen.

8. Vorrichtung (1) nach Anspruch 6 oder 7, **dadurch gekennzeichnet, dass** sie eine Mikroanzeige bildet, deren Pixel eine Seitenlänge von weniger als 50 µm haben und über deren Unterpixel (R, V, B) sich jeweils farbige optische Filter befinden, wobei das Substrat (2) vom Typ mit aktiver Matrix mit den sendenden Strukturen (5) ist, die organische elektrolumineszierende Dioden ("OLED") bilden.

9. Herstellungsverfahren einer Anzeigevorrichtung (1) nach einem der vorangehenden Ansprüche, **dadurch gekennzeichnet, dass** es mindestens einen Trockengravurschritt auf dem Substrat (2) mit den proximalen Elektroden (3) und dem Harz (7), das sie miteinander an ihren jeweiligen peripheren Rändern (3a) verbindet, umfasst, wobei diese Trockengravur durch mechanische Aktion eines Plasmas durchgeführt wird, das gegenüber jeder proximalen Elektrode chemisch inert ist und das daraus einen Teil des nicht von dem Harz bedeckten Materials extrahiert, um es mittels Rückprall auf einem benachbarten Abschnitt (7a) dieses Harzes über diesem Rand zu implantieren, so dass jede derart implantierte Hilfselektrode (8) die proximale Elektrode, aus der sie hervorgegangen ist, vorzugsweise über den gesamten Umfang dieser proximalen Elektrode geneigt verlängert.

10. Herstellungsverfahren nach Anspruch 9, **dadurch gekennzeichnet, dass** für diesen Trockengravurschritt ein Plasma mindestens eines Elements verwendet wird, das aus der letzten Spalte der Periodenklassifizierung ausgewählt ist, wie ein Argonplasma.

11. Herstellungsverfahren nach Anspruch 9 oder 10, **dadurch gekennzeichnet, dass** für jede proximale Elektrode (3) ein metallisches Material verwendet wird, das von einem einfachen Körper gebildet ist, vorzugsweise ausgewählt aus der Gruppe, die von dem Titan, dem Molybdän, dem Wolfram, dem Chrom, dem Nickel, dem Kupfer und dem Gold gebildet ist, damit jede derart implantierte Hilfselektrode (8) infolge der mechanischen Aktion dieses Plasmas von diesem selben Material gebildet ist.

12. Herstellungsverfahren nach Anspruch 9 oder 10, **dadurch gekennzeichnet, dass** für jede proximale Elektrode (3) ein metallisches Material verwendet wird, das von einem zusammengesetzten Körper gebildet ist, ausgewählt aus der Gruppe, die von den leitenden transparenten Oxiden gebildet ist wie den Zinn-Indium-Oxiden, den leitenden metallischen Oxiden der Formel MₓO_{y}, wobei M ein Metall wie das Titan, das Molybdän oder das Wolfram ist, und den leitenden metallischen Nitriden der Formel M'ₓN_{y}, wobei M' ein Metall wie das Titan ist, und dass nach der mechanischen Aktion dieses Plasmas die in Entstehung begriffene Hilfselektrode (8) einem Finish-plasma ausgesetzt wird wie einem O₂- oder N₂-NH₃-Plasma, wenn die proximale Elektrode jeweils aus einem Oxid oder einem metallischen Nitrid hergestellt ist, damit jede derart implantiert Hilfselektrode aus demselben Material wie die proximale Elektrode, aus der sie hervorgegangen ist, gebildet ist.

## Claims

1. Electronic display device (1) comprising an electroluminescent emission face and, towards the interior of this face, a substrate (2) coated with a matrix of pixels, each pixel consisting of an organic light-emitting structure (5) intermediate between and in electrical contact with two electrodes, one (3) near and the other (4) far relative to the substrate respectively, an electrically insulating resin (7) covering the substrate between the respective near electrodes of the pixels and furthermore extending onto a peripheral edge (3a) of each near electrode, **characterized in that** each pixel incorporates at least one auxiliary electrode (8) which is transparent or semitransparent to this light, which is based on a metallic material having a work function identical or substantially identical to that of the near electrode and which extends inclinedly on the surface of this resin and facing said edge, from the near electrode towards the far electrode, so as to maximize the emission area of each pixel and to vary the thickness of the optical cavity formed between the near electrode of each pixel and the far electrode.

2. Device (1) according to claim 1, **characterized in that**, in each pixel, said auxiliary electrode (8) extends obliquely facing the entire perimeter of said peripheral edge (3a) covered by said resin (7) and has a height (H) measured from this edge that is a monotonic increasing function of the width of said edge.

3. Device (1) according to claim 1 or 2, **characterized in that** each auxiliary electrode (8) has a thickness of between 1 nm and 10 nm and is made from a metallic material identical to that of said corresponding near electrode.

4. Device (1) according to claim 3, **characterized in that** the metallic material of each near electrode (3) and of said corresponding auxiliary electrode (8) consists of a chemical element preferably chosen from the group consisting of titanium, molybdenum, tungsten, chromium, nickel, copper and gold.

5. Device (1) according to claim 3, **characterized in that** the metallic material of each near electrode (3) and of said corresponding auxiliary electrode (8) consists of a chemical compound chosen from the group consisting of transparent conductive oxides such as indium tin oxide, conductive metal oxides having the formula MₓO_{y}, where M is a metal such as titanium, molybdenum or tungsten, and conductive metal nitrides having the formula M'ₓN_{y} where M' is a metal such as titanium.

6. Device according to one of the preceding claims, this device being a polychromatic device, **characterized in that** each pixel consists of differently coloured subpixels (R, G, B) that are formed by said organic emitting structure (5) intermediate between and in electrical contact with said near electrodes (3) associated respectively with these subpixels and said far electrode (4), at least one subpixel of each pixel incorporating said at least one auxiliary electrode (8).

7. Device (1) according to claim 6, **characterized in that** each subpixel (R, G, B) of each pixel incorporates said auxiliary electrode (8) that extends facing the entire perimeter of said peripheral edge (3a) covered by said resin (7) and **in that** said emitting structure (5) and said far electrode (4) follow the inclined profile of each auxiliary electrode.

8. Device (1) according to claim 6 or 7, **characterized in that** it forms a microdisplay the pixels of which have a side length of less than 50 µm and have their subpixels (R, G, B) respectively surmounted by optical colour filters, said substrate (2) being an active-matrix substrate with said emitting structures (5) that form organic light-emitting diodes (OLEDs).

9. Process for the fabrication of a display device (1) according to one of the preceding claims, **characterized in that** it comprises at least one dry-etching step carried out on the substrate (2) surmounted by said near electrodes (3) and by the resin (7) that connects them together at their respective peripheral edges (3a), this dry-etching being carried out using the mechanical action of a plasma that is chemically inert with respect to each near electrode and that extracts from it a part of the material not covered by the resin so as to implant it by ricochet onto an adjacent portion (7a) of this resin surmounting this edge, so that each auxiliary electrode (8) thus implanted prolongs the near electrode inclinedly, from which it originates, preferably over the entire perimeter of this near electrode.

10. Fabrication process according to claim 9, **characterized in that** a plasma of at least one element chosen from the last column of the Periodic Table, such as an argon plasma, is used for this dry-etching step.

11. Fabrication process according to claim 9 or 10, **characterized in that** a metallic material consisting of a chemical element, preferably chosen from the group consisting of titanium, molybdenum, tungsten, chromium, nickel, copper and gold, is used for each near electrode (3), so that each auxiliary electrode (8) thus implanted consists of this same material following the mechanical action of this plasma.

12. Fabrication process according to claim 9 or 10, **characterized in that** a metallic material consisting of a chemical compound chosen from the group consisting of transparent conductive oxides such as indium tin oxide, conductive metal oxides having the formula MₓO_{y}, where M is a metal such as titanium, molybdenum or tungsten, and conductive metal nitrides having the formula M'ₓN_{y}, where M' is a metal such as titanium, is used for each near electrode (3) and **in that**, after the mechanical action of this plasma, the as-yet incomplete auxiliary electrode (8) is subjected to a finishing plasma such as an O₂ or N₂-NH₃ plasma, if the near electrode is made of an oxide or a metal nitride respectively, so that each auxiliary electrode thus implanted consists of the same material as the near electrode from which it originates.
